# FASCICULE DE BREVET EUROPEEN

(11) **EP 0 340 107 B1**
(45) Date de publication et mention de la délivrance du brevet: **03.11.1993**
(21) Numéro de dépôt: 89401183.2
(22) Date de dépôt: 26.04.1989
(51) Int. Cl.: G11C 11/56

(54) **Mémoire programmable électriquement avec plusieurs bits d'information par cellule**
Elektrisch programierbarer Speicher mit mehreren bits pro Zelle
Electrically programmable memory with several bits per cell

(30) Priorité: 26.04.1988 FR 8805511
(43) Date de publication de la demande: 02.11.1989
(73) Titulaire: SGS-THOMSON MICROELECTRONICS S.A., 94250 Gentilly (FR)
(72) Inventeur: Devin, Jean CABINET BALLOT-SCHMIT, F-75116 Paris (FR)
(74) Mandataire: Ballot, Paul Denis Jacques

(56) Documents cités:
- IEEE TRANSACTIONS ON COMPUTERS, vol. C-35, no. 2, février 1986, pages 99-106, IEEE, New York, US; D.A. RICH: "A survey of mulitvalued memories"
- IEEE JOURNAL OF SOLID-STATE CIRCUITS, vol. SC-11, no. 4, août 1976, pages 519-528, New York, US; R.A. HEALD et al.: "Multilevel random-access memory using one transistor per cell"
- PATENT ABSTRACTS OF JAPAN, vol. 7, no. 253 (P-235)[1398], 10 novembre 1983, page 104 P 235; & JP-A-58 137 181

## Description

L'invention concerne les mémoires électriquement programmables, et notamment les mémoires connues sous les appellations abrégées "EPROM", "EEPROM", "FLASH-EEPROM" qui correspondent à diverses variantes de mémoires dont la programmation se fait par introduction de charges électriques dans la grille flottante d'un transistor à grille flottante constituant l'élément de base de chaque cellule élémentaire de la mémoire.

La programmation est électrique, ce qui signifie que pour programmer une cellule de la mémoire on désigne cette cellule à l'aide d'un décodeur de ligne et éventuellement un décodeur de colonne, et on applique à la cellule désignée des tensions adéquates permettant d'injecter des charges dans la grille flottante.

L'information stockée dans la mémoire est définie par l'état de programmation de chaque cellule. Cet état de programmation représente une information binaire: une cellule est programmée ou n'est pas programmée.

Pour lire l'information contenue dans la mémoire, on examine l'état de programmation des cellules. Pour cela on adresse une cellule déterminée à l'aide du ou des décodeurs, et on applique des tensions de lecture appropriées à cette cellule. Il en résulte un courant électrique ou une tension qui dépend de l'état de programmation de la cellule. En mesurant ce courant ou cette tension on détermine si la cellule a été ou n'a pas été programmée. On peut ainsi recueillir cellule par cellule ou groupe de cellules par groupe de cellules les informations binaires stockées dans la mémoire.

Plus précisément, par exemple dans le cas où chaque cellule de mémoire est constituée par un transistor à grille flottante, la lecture de l'état de la cellule de mémoire consiste en une comparaison entre le courant issu de la cellule adressée et une valeur de courant de référence. La valeur du courant de référence est choisie sensiblement au milieu de l'intervalle entre la valeur de courant que fournirait une cellule programmée (valeur proche de zéro dans la pratique) et la valeur de courant que fournirait une cellule non programmée, cette cellule programmée et cette cellule non programmée recevant les mêmes tensions de lecture.

Ainsi, un comparateur de courant recevant d'une part le courant de la cellule à lire (à laquelle on applique les tensions de lecture nominales), et d'autre part le courant de référence, basculera franchement dans un sens ou dans un autre selon l'état de programmation de la cellule, fournissant ainsi à sa sortie une information binaire représentant l'information binaire stockée dans la cellule lue.

A titre d'exemple, une cellule EPROM vierge (non programmée) laissera circuler un courant de 200 microampères environ, tandis qu'une cellule programmée ne laissera passer qu'un courant inférieur à 20 microampères dans les mêmes conditions de lecture. La référence choisie pourra être un courant de 100 microampères.

Dans la pratique, le courant issu de la cellule sera de préférence converti en une tension fonction de ce courant (par exemple grâce à un intégrateur), de sorte que la comparaison pourra s'effectuer par un comparateur de tension, souvent plus facile à réaliser qu'un comparateur de courant. Comme le mode de comparaison (par tension ou courant) ne fait pas l'objet de l'invention et qu'on sait bien réaliser des conversions courant-tension, on se contentera dans la suite des explications de parler de comparateurs de courant, en ayant présent à l'esprit qu'il peut s'agir en fait de comparateurs de tension. On peut supposer par exemple que la valeur de référence de comparaison est définie à partir du courant issu d'une cellule vierge de référence, courant appliqué à un convertisseur courant-tension dont le gain définira précisément une tension de référence.

Comme les phénomènes physiques mis en jeu par la programmation sont mal contrôlés industriellement, les courants issus des cellules vierges et des cellules programmées ne sont pas connus avec une grande précision. Ils dépendent de beaucoup de facteurs, y compris des valeurs de tension de lecture appliquées aux cellules. Le courant des cellules programmées dépend en outre de l'intensité de la programmation, c'est-à-dire de la quantité de charges qu'on a réussi à stocker dans la grille flottante d'une cellule; cette quantité de charges dépend de la tension de programmation et de la durée d'application de cette tension, voire encore de la manière dont elle a été appliquée. Il y a donc une très grande dispersion entre les valeurs de courant de cellules vierges et de cellules programmées dans une série de mémoires d'une même fabrication, et même à l'intérieur d'une seule mémoire.

Enfin, la programmation d'une cellule programmée se dégrade au cours du temps, c'est-à-dire que la quantité de charges stockées dans une grille flottante diminue avec le temps, surtout quand la température augmente (la durée de rétention est de l'ordre de 10 ans). Il en résulte que le courant issu d'une cellule programmée augmente progressivement au cours du temps, à mesure que la tension de seuil du transistor à grille flottante diminue par suite de cette perte de charges.

Ces difficultés font qu'on n'a jamais essayé jusqu'à maintenant d'envisager qu'une information autre que binaire soit enregistrée dans une seule cellule physique de la mémoire, c'est-à-dire dans un seul transistor à grille flottante. Pourtant, pour stocker une information autre qu'un bit unique, par exemple une information à trois états ou une information constituée de deux bits, dans une seule cellule, il suffirait de pouvoir définir plusieurs seuils de tension ou de courant fournis par la cellule en mode de lecture (au lieu d'un seul seuil), de sorte que la position du courant ou de la tension par rapport à ces différents seuils définirait l'état de programmation de la cellule parmi plusieurs états (plus de deux) possibles.

On pourrait ainsi gagner beaucoup sur l'encombrement global de la mémoire, tout au moins pour des mémoires de grande capacité dans lesquelles la taille d'une cellule élémentaire est le facteur prédominant d'encombrement. Si une cellule stocke par exemple deux bits d'information au lieu d'un seul en utilisant la même surface élémentaire, on peut évaluer le gain global à environ 25% pour l'ensemble de la mémoire pour une même capacité d'environ 1 Mégabit.

Ce gain de surface se traduit évidemment par une augmentation des rendements de fabrication et donc une diminution des coûts.

La présente invention a pour objet la réalisation d'une mémoire électriquement programmable susceptible de mémoriser dans chaque cellule de mémoire n états de programmation possibles, avec N au moins égal à trois.

Selon l'invention, on propose une mémoire électriquement programmable, dans laquelle la lecture de l'information stockée se fait, en mode de lecture, par comparaison entre d'une part un courant ou une tension fonction de l'état de programmation de la cellule et d'autre part une valeur de référence, caractérisée en ce qu'elle comporte plusieurs circuits de comparaison principaux fonctionnant en mode de lecture pour comparer le courant ou la tension à n-1 valeurs de référence principales d'une suite et en déduire l'état de programmation de la cellule parmi n états possibles où n est au moins égal à trois, et en ce qu'elle comporte par ailleurs plusieurs circuits de comparaison auxiliaires pour comparer le courant ou la tension d'une cellule à des premières valeurs de référence intermédiaires, chaque première valeur de référence intermédiaire étant comprise entre une première et une deuxième valeurs de référence principales consécutives de la suite, la mémoire comportant en outre un circuit logique de commande recevant les sorties des circuits de comparaison principaux et des circuits de comparaison auxiliaires, pour commander l'exécution d'une opération de programmation complémentaire de la cellule si le courant ou la tension est compris entre une valeur de référence principale et la première valeur de référence intermédiaire qui la suit, et pour arrêter cette programmation complémentaire lorsque le courant ou la tension mesurée atteint un seuil déterminé compris entre cette première valeur intermédiaire et une valeur principale qui la suit.

On peut prévoir que ce seuil est identique à la première valeur de référence intermédiaire elle-même, ou au contraire qu'il est constitué par une deuxième valeur intermédiaire, comprise entre la première valeur intermédiaire et la valeur de référence principale qui la suit.

La suite de la description fera mieux comprendre le rôle des valeurs de référence intermédiaires, mais on peut dire en résumé que les valeurs de référence principales définissent les seuils de courant ou tension par rapport auxquels on déterminera l'état de programmation de la mémoire; les premières valeurs de référence intermédiaires définissent des seuils de sécurité permettant de programmer des informations dans les cellules avec un faible risque de perte de charges; les deuxièmes valeurs de référence intermédiaires définissent, pour un état de programmation déterminé, une limite de programmation au delà de laquelle il faut éviter de continuer à programmer la cellule si on ne veut pas risquer de passer à un état de programmation suivant.

Les caractéristiques et avantages de l'invention apparaîtront à la lecture de la description détaillée qui suit et qui est faite en référence aux dessins annexés dans lesquels :
- la figure 1 représente schématiquement une organisation classique de mémoire programmable électriquement;
- la figure 2 représente schématiquement une courbe de courant engendré par une cellule de mémoire en mode de lecture en fonction de l'état de programmation de la cellule, avec la définition classique de deux états de programmation;
- la figure 3 représente schématiquement la même courbe et la manière de stocker dans une seule cellule deux bits d'information définis à l'aide de quatre niveaux de programmation possibles;
- la figure 4 représente encore une courbe de courant avec la définition de trois niveaux de référence principaux et cinq niveaux de référence intermédiaires;
- la figure 5 représente un organigramme de fonctionnement de la mémoire selon l'invention;
- la figure 6 représente un schéma de réalisation de la mémoire selon l'invention.

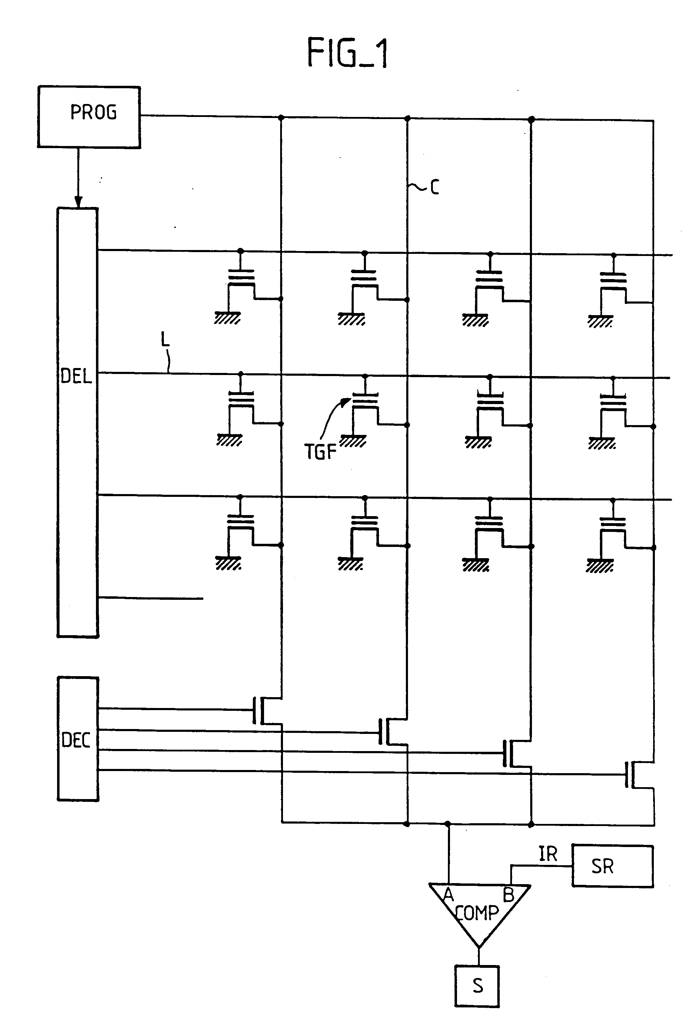

A la figure 1, on reconnaît une mémoire organisée en un réseau de lignes et de colonnes de transistors à grille flottante, chaque transistor constituant une cellule de mémoire individuelle et étant placé au carrefour d'une ligne et d'une colonne de la mémoire.

Les sources des transistors sont reliées à une masse électrique commune, les drains des transistors d'une même colonne sont reliés à un conducteur de colonne spécifique de cette colonne. Les grilles de commande des transistors d'une même ligne sont reliées à un conducteur de ligne spécifique de cette ligne.

Un décodeur de ligne DEL permet de sélectionner une ligne déterminée et d'appliquer au conducteur de ligne correspondant L une tension de lecture (en mode de lecture) ou de programmation (en mode de programmation) ou de test (en mode de test).

Un décodeur de colonne DEC permet de sélectionner une colonne déterminée et de relier le conducteur de colonne correspondant C (en mode de lecture ou de test) à un circuit de lecture qui est symbolisé sur la figure 1 par un comparateur de courant COMP. Le comparateur a alors une première entrée A reliée à une colonne C et une deuxième entrée reliée à une source de courant de référence SR délivrant un courant de référence IR (on se référera à ce qui a été dit plus haut sur la possibilité que la comparaison, porte sur des tensions plutôt que sur des courants). La sortie du comparateur est reliée à une borne de sortie S de la mémoire, borne sur laquelle apparaissent les niveaux logiques correspondant aux informations programmées dans les cellules. On peut noter que les informations à stocker dans les cellules sont également appliquées sur la borne S, à partir de l'extérieur, pour être transmises vers les colonnes en mode de programmation.

En mode de lecture comme en mode de test ou de programmation, le transistor à grille flottante TGF situé à l'intersection de la ligne L et de la colonne C est sélectionné et peut être lu ou testé ou programmé.

Sur la figure 1 on a en outre représenté symboliquement un circuit de programmation PROG qui fournit les tensions nécessaires à la programmation, plus élevées qu'en mode de lecture ou test.

Le test consiste en pratique à appliquer les mêmes tensions qu'en mode de lecture et à vérifier que pour chaque cellule testée le comparateur COMP fournit sur la borne de sortie S un niveau logique correspondant à l'information théoriquement stockée dans la cellule : niveau 0 pour les cellules programmées, niveau 1 pour les cellules non programmées.

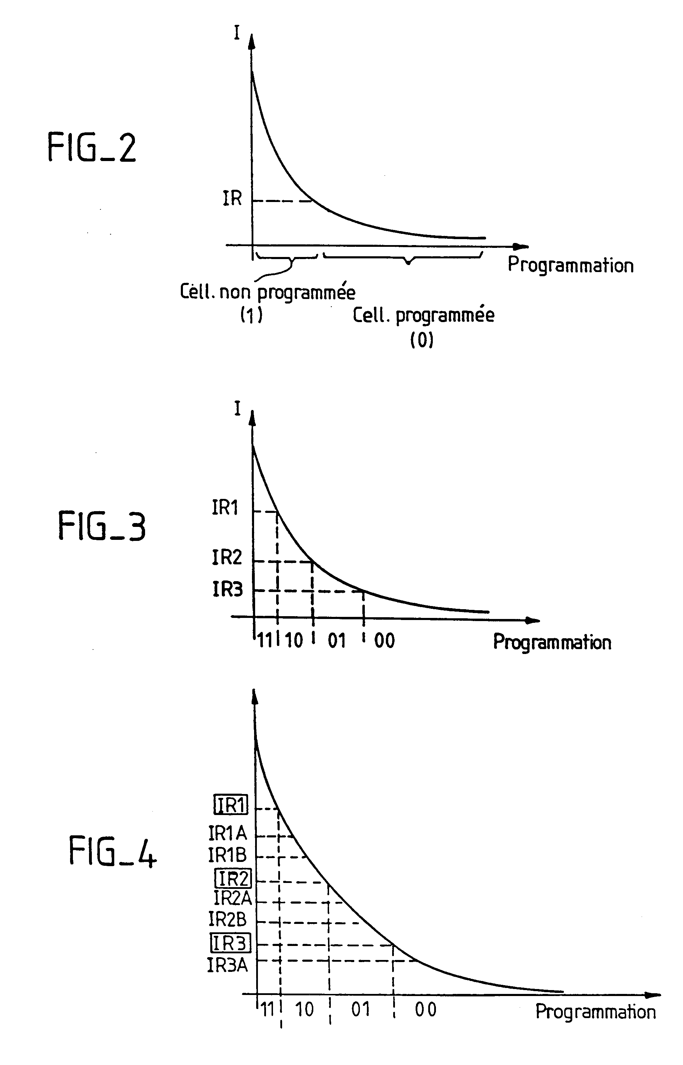

Sur la figure 2 on a représenté la courbe du courant en fonction de l'état de programmation de la cellule; plus la programmation est forte, plus le courant engendré en mode de lecture est faible; pour programmer plus fortement, on augmente soit les tensions appliquées à la cellule en mode de programmation , soit la durée d'application, soit encore le nombre d'impulsions de tensions de programmation calibrées.

Un niveau de courant de référence IR, intermédiaire entre le courant normalement engendré par une cellule vierge et le courant normalement engendré par une cellule programmée, permet de distinguer deux états de programmation de la cellule. La cellule est vierge (état 1) si le courant lu est supérieur à IR; elle est programmée (état 0) si le courant est inférieur à IR. L'information stockée par une cellule est une information binaire.

Sur la figure 3, on a représenté, pour la même courbe de courant en fonction de l'intensité de la programmation, trois niveaux de référence de courant, IR1, IR2, IR3 dans l'ordre décroissant. Ces trois niveaux définissent quatre états de programmation possibles, donc une information à deux bits.

Par exemple, l'état 11 correspond à une cellule vierge (premier niveau de programmation, correspondant à une absence de programmation), le courant engendré en lecture étant supérieur à IR1; l'état 10 correspond à un deuxième niveau pour lequel le courant engendré est compris entre IR1 et IR2; l'état O1 correspond au troisième niveau (I compris entre IR2 et IR3), et l'état 00 au quatrième niveau (I compris entre IR3 et zéro).

La figure 4 représente encore la même courbe, mais avec d'autres valeurs de courant de référence qui sont des valeurs de référence intermédiaires entre les valeurs de référence principales IR1, IR2, IR3, définies à la figure 3. Ces valeurs se décomposent en des premières valeurs de référence intermédiaires IR1A, IR2A, IR3A, et des deuxièmes valeurs de référence intermédiaires IR1B et IR2B. Les premières valeurs intermédiaires IR1A, IR2A et IR3A sont les plus importantes et d'ailleurs dans un cas particulier de réalisation, on peut très bien prévoir que les deuxièmes valeurs sont identiques aux premières (c'est-à-dire plus précisément que IR1B=IR1A et IR2B=IR2A).

Chaque valeur de référence intermédiaire est comprise entre deux valeurs principales consécutives de la suite IR1, IR2, IR3; la valeur IR1A est comprise entre IR1 et IR2; la valeur IR2A est comprise entre IR2 et IR3, etc.

Si les deuxièmes valeurs de référence intermédiaires ne sont pas identiques aux premières, alors, la suite des valeurs est, dans l'ordre des valeurs de courant correspondant à des programmations croissantes : première valeur principale (par exemple IR2), puis première valeur intermédiaire (IR2A), puis deuxième valeur intermédiaire (IR2B), et enfin deuxième valeur principale (IR3).

On définit alors les mêmes états de programmation qu'à la figure 3, c'est-à-dire quatre états 11, 10, 01, 00, que l'on distingue les uns des autres en fonction des niveaux de référence principaux IR1, IR2, IR3. En mode de lecture, on comparera le courant engendré par la cellule à ces trois valeurs et on en déduira, par un circuit logique simple, les deux bits de l'information contenue dans la cellule.

Les premiers niveaux intermédiaires de référence définissent des niveaux de sécurité de programmation. On considère selon l'invention qu'une cellule qui doit être programmée au n^{ième} état (par exemple le 2^{ème} état dont la représentation binaire est 10) doit fournir non seulement un courant compris entre les valeurs de référence IRn-1 et IRn (ici IR1 et IR2) où IRn-1 représente le seuil de passage entre l'état n-1 et l'état n, mais plus précisément un courant inférieur à la valeur de référence auxiliaire IRₙ₋₁A qui suit immédiatement (dans le sens des courants correspondant à une programmation croissante) la valeur de référence principale IRₙ₋₁. Dans le cas contraire, si le courant engendré est trop proche de la valeur de référence qui définit le passage entre le niveau de programmation n-1 et le niveau n, on considère que la cellule est insuffisamment programmée et qu'il y a un risque notable de pertes de charges au cours du temps. On ne peut pas accepter ce risque dans un contexte où les niveaux de programmation doivent être d'autant plus parfaitement définis que leur nombre est plus grand et que les courants correspondant aux changements de niveau de programmation sont plus proches les uns des autres.

Les deuxièmes niveaux de référence intermédiaire définissent d'une manière un peu analogue (mais on verra que leur importance est moins grande que celle des premiers) des limites de programmation au delà desquelles il ne faut pas continuer de programmer une cellule si on ne veut pas risquer de la programmer à l'état suivant.

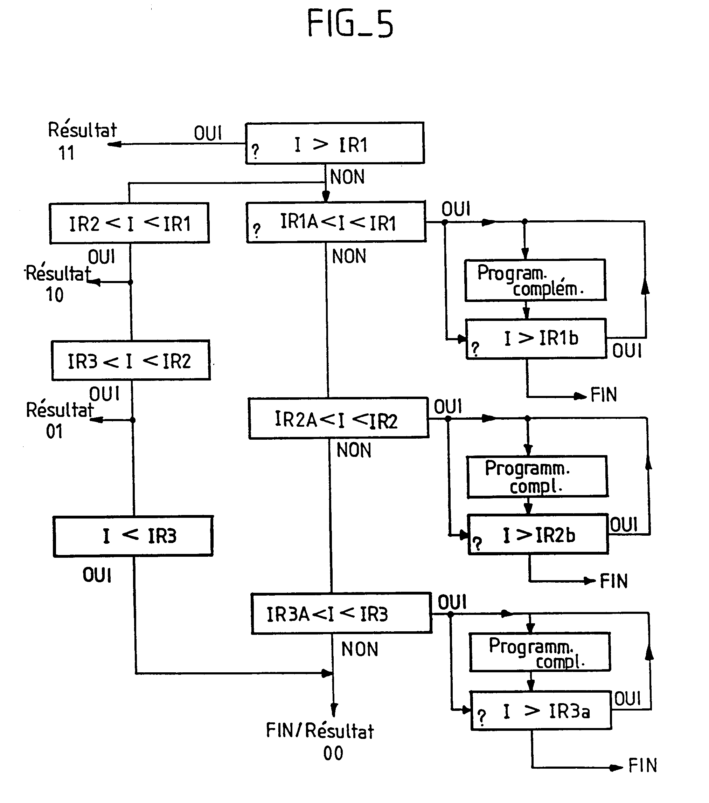

La figure 5 représente sous forme d'un organigramme le déroulement des opérations de lecture de la mémoire selon l'invention.

On compare le courant I issu de la cellule successivement ou simultanément aux valeurs de référence principales IR1, IR2, IR3. A chaque tranche de courant correspond un résultat de mesure définissant l'état de la programmation de la cellule; si l'état est bien celui que l'on veut l'information stockée est la bonne; sinon il faut recommencer la programmation ou éventuellement mettre la mémoire au rebut.

Le test plus spécifique proposé par l'invention consiste à comparer en outre, simultanément ou successivement, le courant issu de la cellule en mode de test à la fois aux valeurs principales de référence IR1, IR2, IR3, et aux valeurs de référence intermédiaires qui les suivent immédiatement : IR1A, IR2A, IR3A.

Si le courant est compris entre une valeur de référence principale IRn et la valeur de référence intermédiaire IRnA qui la suit immédiatement dans l'ordre des courants correspondant à des programmations croissantes, alors une programmation complémentaire est déclenchée. Cette programmation consiste par exemple en l'application d'impulsions de tensions de programmation aux électrodes de la cellule et on peut prévoir qu'après chaque impulsion ou groupe d'impulsions, un nouveau test est effectué.

La programmation complémentaire est arrêtée quand le courant issu de la cellule testée devient inférieur à la deuxième valeur de référence intermédiaire (IR1B, IR2B) qui suit immédiatement la première valeur intermédiaire pour laquelle le test a indiqué que la programmation était insuffisante.

Le plus simple est de prendre pour valeur de IRnB la même valeur que IRnA (on économise des comparateurs); mais la sécurité de programmation peut être plus élevée si les deuxièmes valeurs intermédiaires IRnB sont différentes des premières IRnA.

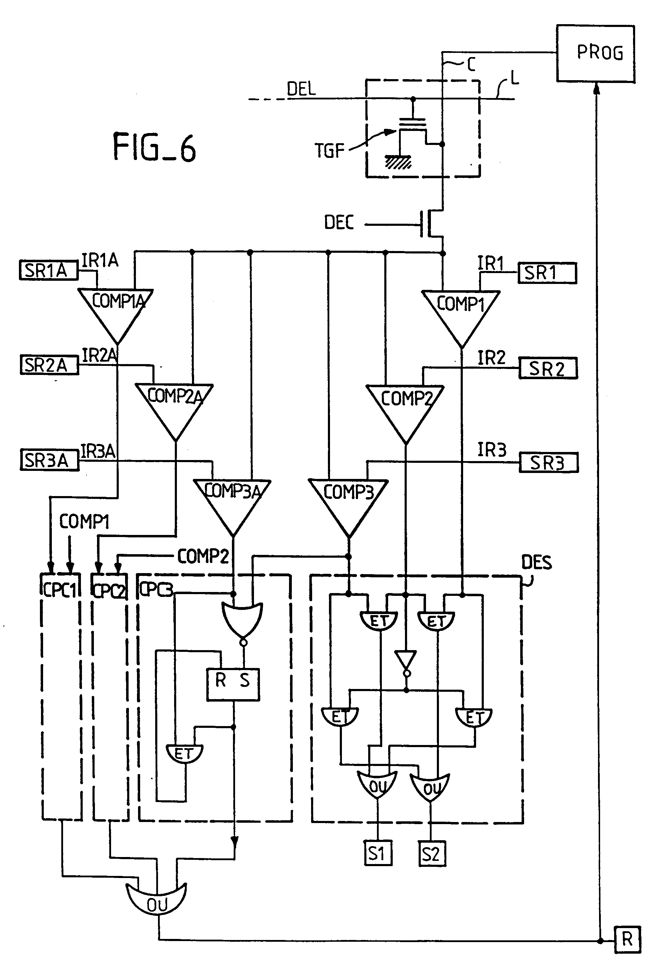

La figure 6 représente un mode de réalisation de la mémoire selon l'invention dans le cas où les premières et deuxièmes valeurs de référence sont identiques, mais un schéma pourrait être proposé sans difficulté si les valeurs étaient différentes, compte-tenu des explications données dans cette description. Il faudrait des comparateurs supplémentaires pour comparer le courant aux deuxièmes valeurs de référence intermédiaires.

Pour simplifier on n'a représenté sur la figure 6 qu'une seule cellule du réseau de mémoire (transistor TGF au carrefour d'une ligne L et d'une colonne C), sélectionnée en lecture par le décodeur de ligne DEL et le décodeur de colonne DEC.

Des comparateurs COMP1, COMP2, COMP3 sont prévus pour comparer le courant issu de la cellule sélectionnée aux valeurs de référence principales IR1, IR2, IR3, délivrées par des sources de courant de référence SR1, SR2, SR3.

Les sorties de ces comparateurs sont appliquées à un circuit logique de décodage de sortie DES qui a trois entrées et deux sorties et qui délivre sur deux plots de sortie S1 et S2 de la mémoire une information en deux bits sur l'état de programmation de la cellule lue, cet état étant défini par les sorties des comparateurs.

Des comparateurs auxiliaires COMP1A, COMP2A, COMP3A, associés chacun à l'un des comparateurs COMP1, COMP2, COMP3, sont prévus pour comparer le courant de la cellule aux premières valeurs de référence intermédiaires IR1A, IR2A, IR3A, fournies par des sources de courant SR1A, SR2A, SR3A.

La sortie d'un comparateur, COMP3 par exemple, et la sortie du comparateur auxiliaire associé COMP3A, sont reliées aux entrées d'un circuit logique de commande de programmation complémentaire; ce circuit de commande est désigné par la référence CPC1 pour le circuit qui reçoit les sorties des comparateurs COMP1 et COMP1A, par la référence CPC2 pour celui qui reçoit les sorties de COMP2 et COMP2A, et par CPC3 pour celui qui reçoit les sorties de COMP3 et COMP3A.

Ces circuits ont une double fonction : tout d'abord détecter qu'un courant d'une cellule sélectionnée est compris entre une valeur de référence principale et la valeur de référence intermédiaire qui la suit immédiatement, et déclencher alors une commande de programmation complémentaire; puis, lorsque cette commande a été déclenchée, interrompre la programmation complémentaire lorsque le courant de la cellule testée passe au dessous de la valeur de référence intermédiaire qui a servi a déclencher la commande de programmation complémentaire.

Les sorties des circuits CPC1, CPC2, CPC3 sont appliquées par exemple à une porte OU dont la sortie, fournit un signal de commande unique de programmation complémentaire, quel que soit le groupe de comparateurs qui a déclenché l'ordre.

Ce signal de commande unique est appliqué par exemple directement à un circuit de programmation PROG permettant d'appliquer les diverses tensions de programmation aux cellules de la mémoire.

Mais le signal de commande de programmation complémentaire peut aussi être appliqué à une borne R de sortie du circuit intégré de mémoire, cette borne étant reliée à un microprocesseur apte à commander la reprogrammation de la mémoire. Lorsque le microprocesseur reçoit le signal de commande, il interrompt momentanément le fonctionnement normal de la mémoire et exécute une séquence de programmation complémentaire. Des opérations successives de reprogrammations peuvent être effectuées jusqu'à ce que le courant de sortie I de la cellule devienne inférieur au courant IRnA.

Le détail du circuit CPC3 est donné, à titre d'exemple, sur la figure 6; les circuits CPC1 et CPC2 peuvent être identiques au circuit CPC3.

Dans l'exemple donné, le comparateur COMP3 fournit un niveau logique 0 pour une cellule programmée au niveau 00, délivrant un courant I inférieur à IR3, et un niveau logique 1 pour une cellule programmée à un niveau inférieur 01, 10, ou 11 et délivrant un courant I supérieur à IR3.

Le comparateur COMP3A fournit un niveau logique 0 si le courant issu de la cellule est supérieur à IR3A et un niveau logique 1 s'il est inférieur à IR3A.

De cette manière, les comparateurs COMP3 et COMP3A fournissent tous deux un niveau logique 0 si le courant délivré par une cellule est compris entre les deux valeurs de référence IR3 et IR3A. Une porte NON-OU détecte ce cas et délivre un signal de commande qui servira à déclencher la programmation complémentaire.

La sortie de la porte OU peut être appliquée à l'entrée de basculement S d'une bascule RS; la sortie de la bascule constitue la sortie du circuit CPC3 (niveau logique 1 lorsque le test effectué par les comparateurs COMP3 et COMP3A aboutit à la conclusion que le courant est compris entre IR3 et IR3A).

La sortie de la bascule est appliquée à une entrée d'une porte ET dont une autre entrée est validée par la sortie du comparateur COMP3A lorsque le courant devient inférieur à IR3A. La sortie de la porte ET est connectée à l'entrée de rétablissement R de la bascule RS. Ainsi, la bascule déclenche bien un ordre de programmation complémentaire pour un courant compris entre IR3 et IR3A, puis cet ordre subsiste grâce à la bascule; enfin l'ordre est interrompu par remise à zéro de la bascule lorsque le courant testé devient inférieur à IR3A.

On s'assure ainsi en permanence que les cellules sont programmées non seulement au niveau désiré, mais encore avec une sécurité de programmation contre les pertes de charges inévitables au cours du temps.

## Revendications

1. Mémoire électriquement programmable, dans laquelle la lecture de l'information stockée se fait, en mode de lecture, par comparaison entre d'une part un courant (I) ou une tension fonction de l'état de programmation de la cellule et d'autre part une valeur de référence (IR), caractérisée en ce qu'elle comporte plusieurs circuits de comparaison principaux (COMP1, COMP2, COMP3) fonctionnant en mode de lecture pour comparer le courant ou la tension à n-1 valeurs de référence principales (IR1, IR2, IR3) d'une suite et en déduire l'état de programmation de la cellule parmi n états possibles où n est au moins égal à trois, et en ce qu'elle comporte par ailleurs plusieurs circuits de comparaison auxiliaires (COMP1A, COMP2A) pour comparer le courant ou la tension d'une cellule à des premières valeurs de référence intermédiaires (IR1A, IR2A), chaque première valeur de référence intermédiaire étant comprise entre une première et une deuxième valeurs de référence principales consécutives de la suite, la mémoire comportant en outre un circuit logique de commande (CPC1, CPC2, CPC3) recevant les sorties des circuits de comparaison principaux et des circuits de comparaison auxiliaires, pour commander l'exécution d'une opération de programmation complémentaire de la cellule testée si le courant ou la tension est compris entre une valeur de référence principale et la première valeur de référence intermédiaire qui la suit, et pour arrêter cette programmation complémentaire lorsque le courant ou la tension mesurée atteint un seuil déterminé compris entre cette première valeur intermédiaire et une valeur principale qui la suit.

2. Mémoire selon la revendication 1, caractérisée en ce que le seuil déterminé est égal à la première valeur de référence intermédiaire.

3. Mémoire selon la revendication 1, caractérisé en ce que le seuil déterminé est une deuxième valeur intermédiaire (IR1B, IR2B, IR3B) comprise entre la première valeur intermédiaire et la valeur de référence principale qui la suit.

## Claims

1. Electrically programmable memory, wherein the data stored are read, in read mode, by means of a comparison between on the one hand a current (I) or a voltage which is a function of the programmed state of the cell and on the other hand a reference value (IR), characterised in that it includes several principal comparator circuits (COMP1, COMP2, COMP3) working in read mode, for comparing the current or voltage with n-1 principal reference values (IR1, IR2, IR3) of a sequence and deducing therefrom the programmed state of the cell from amongst n possible states, where n is at least three, and in that it also includes several auxiliary comparator circuits (COMP1A, COMP2A) for comparing the current or voltage of a cell with first intermediate reference values (IR1A, IR2A), each first intermediate reference value being between first and second principal reference values which are consecutive values of the sequence, the memory also including a logic control circuit (CPC1, CPC2, CPC3) receiving the outputs of the principal comparator circuits and the auxiliary comparator circuits, in order to control the execution of an operation for supplementary programming of the tested cell if the current or voltage is between a principal reference value and the first intermediate reference value which follows it, and to stop this supplementary programming when the current or voltage measured reaches a determined threshold between this first intermediate value and a principal value following it.

2. Memory according to Claim 1, characterised in that the determined threshold is equal to the first intermediate reference value.

3. Memory according to Claim 1, characterised in that the determined threshold is a second intermediate value (IR1B, IR2B, IR3B) between the first intermediate value and the principal reference value following it.

## Patentansprüche

1. Elektrisch programmierbarer Speicher, in dem das Lesen der gespeicherten Information in der Lesebetriebsart durch Vergleichen einerseits eines Stroms (I) oder einer Spannung, die vom programmierten Zustand der Zelle abhängen, mit einem Bezugswert (IR) andererseits ausgeführt wird, dadurch gekennzeichnet, daß er mehrere Hauptvergleichsschaltungen (COMP1, COMP2, COMP3) enthält, die in der Lesebetriebsart arbeiten, um den Strom oder die Spannung mit n-1 Hauptbezugswerten (IR1, IR2, IR3) einer Folge zu vergleichen und daraus den programmierten Zustand der Zelle aus n möglichen Zuständen abzuleiten, wobei n wenigstens gleich drei ist, und daß er andererseits mehrere Hilfsvergleichsschaltungen (COMP1A, COMP2A) enthält, um den Strom oder die Spannung einer Zelle mit ersten Zwischenbezugswerten (IR1A, IR2A) zu vergleichen, wobei jeder erste Zwischenbezugswert zwischen einem ersten und einem zweiten von aufeinanderfolgenden Hauptbezugswerten der Folge liegt, wobei der Speicher außerdem eine Steuer-Logikschaltung (CPC1, CPC2, CPC3) enthält, die die Ausgänge der Hauptvergleichsschaltungen und der Hilfsvergleichsschaltungen empfängt, um die Ausführung einer komplementären Programmieroperation der geprüften Zelle zu steuern, falls der Strom oder die Spannung zwischen einem Hauptbezugswert und dem ersten ihm folgenden Zwischenbezugswert liegt, und um diese komplementäre Programmierung anzuhalten, wenn der gemessene Strom oder die gemessene Spannung einen vorgegebenen Schwellenwert erreicht, der zwischen diesem ersten Zwischenwert und einem ihm folgenden Hauptwert liegt.

2. Speicher gemäß Anspruch 1, dadurch gekennzeichnet, daß der bestimmte Schwellenwert gleich dem ersten Zwischenbezugswert ist.

3. Speicher gemäß Anspruch 1, dadurch gekennzeichnet, daß der bestimmte Schwellenwert ein zweiter Zwischenwert (IR1B, IR2B, IR3B) ist, der zwischen dem ersten Zwischenwert und dem ihm folgenden Hauptbezugswert liegt.
